# EUROPÄISCHE PATENTSCHRIFT

(11) **EP 3 332 479 B1**
(45) Veröffentlichungstag und Bekanntmachung des Hinweises auf die Patenterteilung: **05.01.2022**
(21) Anmeldenummer: 16710135.1
(22) Anmeldetag: 11.03.2016
(51) Int. Cl.: H03K 17/08, H03K 5/08, H02H 9/04, H01L 27/02

(54) **SCHALTUNGSANORDNUNG ZUM SCHUTZ EINER AUS EINEM VERSORGUNGSNETZ ZU BETREIBENDEN EINHEIT GEGEN ÜBERSPANNUNGEN**
CIRCUIT ASSEMBLY FOR PROTECTING A UNIT TO BE OPERATED FROM A SUPPLY NETWORK AGAINST OVERVOLTAGE
CIRCUIT SERVANT À PROTÉGER CONTRE LES SURTENSIONS UNE UNITÉ FONCTIONNANT À PARTIR D'UN RÉSEAU D'ALIMENTATION

(30) Priorität: 06.08.2015 DE 102015010325; 15.02.2016 DE 102016001742
(43) Veröffentlichungstag der Anmeldung: 13.06.2018
(73) Patentinhaber: DEHN SE + Co KG, 92318 Neumarkt / Opf. (DE)
(72) Erfinder: BÖHM, Thomas, 92366 Hohenfels (DE); SCHORK, Franz, 90461 Nürnberg (DE)
(74) Vertreter: Prinz & Partner mbB
(86) Internationale Anmeldenummer: PCT/EP2016/055222
(87) Internationale Veröffentlichungsnummer: WO 2017/021013

(56) Entgegenhaltungen:
- US-A- 3 246 206
- US-A1- 2004 125 521
- US-A1- 2011 261 489
- US-B2- 6 542 022

## Beschreibung

Die Erfindung betrifft eine Schaltungsanordnung zum Schutz einer aus einem Versorgungsnetz zu betreibenden Einheit gegen Überspannungen mit einem Eingang mit erstem und zweitem Eingangsanschluss, die mit dem Versorgungsnetz in Verbindung stehen, und einem Ausgang mit einem ersten und einem zweiten Ausgangsanschluss, an denen die zu schützende Einheit anschließbar ist, sowie mit einer Schutzschaltung, die zwischen erstem und zweitem Eingangsanschluss vorgesehen ist, um die an ihr anliegende Spannung zu begrenzen, wobei die Schutzschaltung einen Leistungshalbleiter (IGBT) und eine Ansteuerung für den Leistungshalbleiter aufweist, gemäß Patentanspruch 1.

Aus der DE 10 2012 223 088 A1 ist eine Steuerschaltung für Leistungshalbleiter vorbekannt, die auch zum Ansteuern von IGBTs geeignet ist. Die dortige Steuerschaltung verfügt über eine Zeitgebereinrichtung, die in Reaktion auf das Ansteuerungsschaltungssignal zwischen verschiedenen Ansteuerungssystemen einen Umschaltvorgang auslöst. Diesbezüglich weist die vorbekannte Schaltung den Vorteil auf, dass ein verringertes EMI-Rauschen und die Möglichkeit des Fortfalls einer Gatespannungsüberwachung vorliegt.

Bei dem intelligenten Leistungsmodul mit Halbleiterbauelement und Treiberschaltung zur Ansteuerung des IGBTs nach EP 1 292 027 B1 weisen parallel geschaltete IGBT-Module integrierte Treiberschaltungen auf, die dem internen Schutz dort vorhandener Bauteile dienen und Leistungshalbleiter zum Schutz vor Überlastungen abschalten.

Aus der US2004/0125521 A1 ist eine Schaltungsanordnung zum Schutz von Hardware der Bauelemente gegen elektrostatische Entladungen bekannt.

Aus dem Vorgenannten ist es Aufgabe der Erfindung, eine weiterentwickelte Schaltungsanordnung zum Schutz einer aus einem Versorgungsnetz zu betreibenden Einheit gegen Überspannungen anzugeben, wobei eine Schutzschaltung vorgesehen ist, um die am Eingang anliegende Spannung zu begrenzen. Dabei wird für die Schutzschaltung auf mindestens einen Leistungshalbleiter, insbesondere einen IGBT nebst Ansteuerung für diesen Leistungshalbleiter zurückgegriffen. Gemäß der Aufgabe der Erfindung soll der Treiber für die Schutzschaltung nicht im Dauerbetrieb arbeiten, sondern lediglich bei Überspannungsereignissen aktiv werden. Der Treiber soll weiterhin in der Lage sein, autonom zu arbeiten, um den gewünschten Schutzzweck auch ohne übergeordnete Steuersignale in Verbindung mit dem Leistungshalbleiter zu bewirken.

Die Lösung der Aufgabe der Erfindung erfolgt mit einer Schaltungsanordnung gemäß der Merkmalskombination nach Anspruch 1, wobei die Unteransprüche mindestens zweckmäßige Ausgestaltungen und Weiterbildungen darstellen.

Ein Grundgedanke der Erfindung liegt demgemäß darin, eine Logikbaugruppe vorzusehen, welche in der Lage ist, Überspannungsereignisse zu erkennen. Diese Logikbaugruppe übernimmt dann die Funktion des Ansteuerns des Leistungshalbleiters für die Zeit erkannter transienter Überspannungsereignisse.

Um den eingesetzten Leistungshalbleiter in die Lage zu versetzen den erforderlichen Stoßstrom zu übernehmen, wird erfindungsgemäß dafür gesorgt, dass der Leistungshalbleiter mit einer erhöhten Gatespannung von bis zu 100 V und entsprechend steiler Schaltflanke angesteuert wird. Eine Erhöhung der Gatespannung führt im Regelfall zu einer quadratischen Steigerung des Sättigungsstroms eines entsprechend angesteuerten Leistungshalbleiters.

Weiterhin ist die Logikbaugruppe in der Lage, eine zeitliche Koordination des Stoßstromableiters, d.h. des Leistungshalbleiters, nebst zusätzlich eingesetztem Folgestrombegrenzer in Form eines Thyristors zu übernehmen.

Die Logikbaugruppe ist demnach in der Lage, schnelle transiente Ereignisse auszuwerten, wie z.B. eine Spitzendetektion des Stoßstroms vorzunehmen, eine Ladungsdetektion des Stoßstroms zu realisieren oder als Impulszähler zu wirken.

In Weiterbildung der Erfindung ist an den Ausgangsanschlüssen, quasi parallel zum Leistungshalbleiter, ein Thyristor vorgesehen, welcher mit der Logikbaugruppe in Verbindung steht, wobei die Logikbaugruppe zeitlich koordiniert den Thyristor zum Zweck der Folgestrombegrenzung aktiviert.

Im Weiteren weist die Logikbaugruppe Mittel zur Bewertung von Überspannungsereignissen im Nanosekundenbereich auf und stellt ein Ausgangssignal zur Ansteuerung des Leistungshalbleiters in Abhängigkeit von der erkannten Überspannungsimpulslänge bereit.

Die erfindungsgemäße Logikbaugruppe umfasst in einer bevorzugten Ausgestaltung einen Mikrokontroller, dessen Signaleingang ein Komparator parallel geschalten ist.

Der Ausgang des Mikrokontrollers und des Komparators ist auf je einen Eingang einer Verstärkerschaltung gelegt, deren Ausgang auf das Gate des Leistungshalbleiters führt. Am Eingang der Einheit gegen Überspannungen ist eine TVS-Diode angeschlossen, die mit dem Signaleingang des Mikrokontrollers und des dort ebenfalls angeschlossenen Komparators in Verbindung steht und bei Durchbruch ein Triggersignal liefert.

Der Mikrokontroller besitzt durch seine vorgegebene Taktfrequenz eine begrenzte Reaktionsgeschwindigkeit. Dieses Problem wird durch das Parallelschalten des erwähnten Komparators gelöst. Der Komparator übernimmt im ersten Moment des Überspannungsimpulses die Ansteuerung der Verstärkerschaltung und damit des Leistungshalbleiters. Sobald der Mikrokontroller die Steuerung übernehmen kann, wird der Komparator abgeschaltet, da nur der tatsächliche Einschaltmoment sich als zeitkritisch darstellt.

In Weiterbildung der Erfindungslehre ist der Leistungshalbleiter mit einer weiteren TVS-Diode an seinem Gate geclamped, um die Reaktionszeit des Komparators und der als Treiber wirkenden Verstärkerschaltung zu überbrücken.

Die Erfindung soll nachstehend anhand von Ausführungsbeispielen sowie unter Zuhilfenahme von Figuren näher erläutert werden.

Hierbei zeigen:
- Fig. 1: ein Blockschaltbild der erfindungsgemäßen Schaltungsanordnung und
- Fig. 2: eine Ausführungsform der Logikbaugruppe mit Treiberfunktion zur Ansteuerung des Leistungshalbleiters (IGBT).

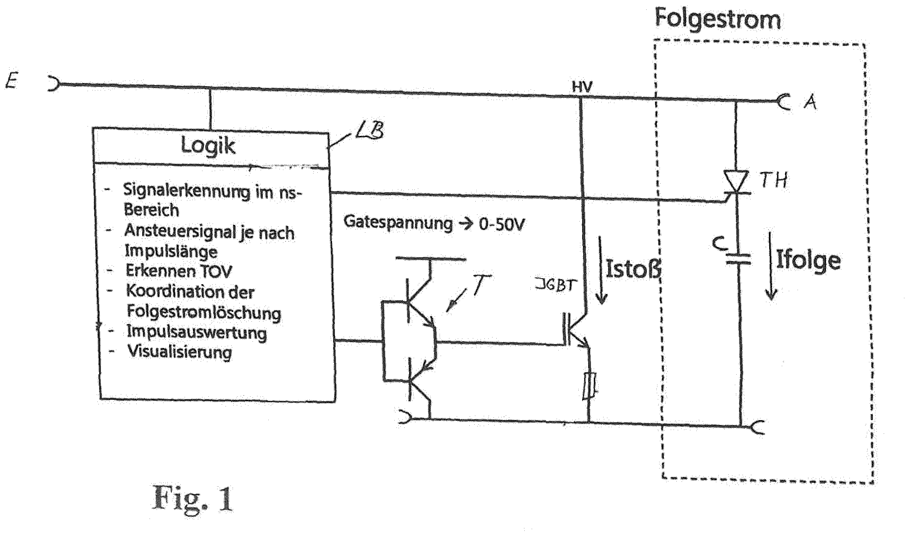

Die Schaltungsanordnung nach Fig. 1 weist einen Eingang E und einen Ausgang A auf. Am Eingang E liegt Spannung eines Versorgungsnetzes an. Am Ausgang A ist eine zu schützende Einheit (nicht dargestellt) anschließbar.

Die Schaltungsanordnung umfasst eine Schutzschaltung, die aus einem Leistungshalbleiter IGBT und einem Thyristor TH besteht. Im Überspannungsfall übernimmt der Leistungshalbleiter IGBT den Stoßstrom. Der Thyristor TH hingegen dient als Folgestrombegrenzer Ifolge.

Das Gate des Leistungshalbleiters IGBT steht mit dem Ausgang eines Treibers T, der als Verstärker ausgebildet ist, in Verbindung, dessen Eingang am Ausgang einer Logikbaugruppe LB angeschlossen ist.

Eingangsseitig steht die Logikbaugruppe LB mit dem Eingang der Schaltungsanordnung, d.h. mit dem Netz in Verbindung.

Die Logikbaugruppe übernimmt die Erkennung von Störspannungsereignissen und stellt ein Ansteuersignal je nach erkannter Impulslänge bereit. Dabei kann die Logikbaugruppe sowohl TOV-Ereignisse erkennen als auch eine Koordination der Stoßstromlöschung Istoß und der Folgestromlöschung Ifolge übernehmen. Zusätzlich ist eine allgemeine Impulsauswertung und eine Visualisierung im Sinne einer Belastungserkennung der Schaltungsanordnung möglich.

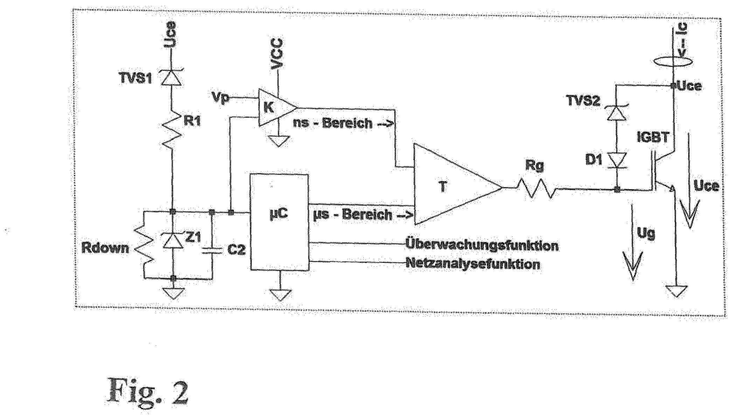

Die Darstellung nach Fig. 2 betrifft ein konkretes Ausführungsbeispiel für die Ausgestaltung der Logikbaugruppe nebst Treiber im Sinne einer schnellen Treiberschaltung für den IGBT.

Am Eingang der diesbezüglichen Schaltungsanordnung ist eine erste TVS-Diode TVS1 angeschlossen. Diese liefert dem Mikrokontroller µC an dessen Eingang ein Triggersignal. Der Mikrokontroller µC weist bei einer Taktfrequenz von beispielsweise maximal 10 MHz eine limitierte Reaktionsgeschwindigkeit im Bereich von 1 bis 2 µs auf. Aus diesem Grund ist gemäß der Darstellung nach Fig. 2 ein Komparator K am Eingang des Mikrokontrollers µC angeschlossen, welcher eine Reaktionsgeschwindigkeit von ca. 4 ns aufweist. Es liegt damit der Komparator K parallel zum Mikrokontroller µC. Der Komparator K übernimmt im ersten Moment des von der TVS-Diode TVS1 gelieferten Impulses die Ansteuerung der Schaltung, bis der Mikrokontroller µC aktiv wird.

Der Komparator K kann beispielsweise als Operationsverstärker ausgeführt werden. Alternativ kann auch ein MOSFET zum Einsatz kommen, dessen Thresholdspannung als Referenzspannung gilt und somit eine gleiche Funktionalität wie ein Operationsverstärker bewirkt wird. Eine solche Realisierung ist kostengünstiger und reduziert auch den Energieverbrauch der Treiberschaltung.

Sobald der Mikrokontroller µC die Steuerung übernommen hat, schaltet dieser den Komparator K ab, da letztendlich nur der eigentliche Einschaltmoment zeitkritisch ist.

Während des Abschaltens kann die Reaktionszeit des Mikrokontrollers µC hingenommen werden.

Zusätzlich ist der IGBT zwischen seinem Gate und seinem Kollektor mit einer weiteren TVS-Diode TVS2 zur Ausbildung einer Clampingschaltung versehen. Hierdurch wird die Reaktionszeit des Komparators K und der Verstärkerschaltung T mit Treiberfunktion überbrückt.

Der Verstärker T stellt eine erhöhte Spannung am Gate des IGBT zur Verfügung, so dass sich die Stoßstromtragfähigkeit des Leistungshalbleiters IGBT in dem gewünschten Maße erhöht.

Der Mikrokontroller µC kann darüber hinaus Überwachungsfunktionen bezogen auf die Funktionsweise der ganzen Schaltungsanordnung, aber auch Netzanalysefunktionen übernehmen.

Mit dem Bezugszeichen R_{g} ist der Gatevorwiderstand symbolisiert. Dieser Gatevorwiderstand kann aus einer Reihen- oder Parallelschaltung mehrerer Widerstände und Dioden bestehen. Der Gatevorwiderstand bestimmt die Schaltgeschwindigkeit des IGBT.

Der Widerstand R1 dient der Strombegrenzung durch die Dioden TVS1 und Z1.

Der Kondensator C2 sorgt für eine Entstörung des Eingangs des Mikrokontrollers µC. Insofern bilden R1 und C2 einen Tiefpass. Hierdurch werden Fehitriggerungen verhindert. Der Tiefpass kann auch als Verzögerungsglied Verwendung finden.

## Patentansprüche

1. Schaltungsanordnung zum Schutz einer aus einem Versorgungsnetz zu betreibenden Einheit gegen Überspannungen mit einem Eingang (E) mit erstem und zweitem Eingangsanschluss, die mit dem Versorgungsnetz verbindbar sind, und einem Ausgang (A) mit einem ersten und einem zweiten Ausgangsanschluss, an denen die zu schützende Einheit anschließbar ist, sowie mit einer Schutzschaltung, die zwischen erstem und zweitem Eingangsanschluss vorgesehen ist, um die an ihr anliegende Spannung zu begrenzen, wobei die Schutzschaltung einen Leistungshalbleiter (IGBT) und eine Ansteuerung für den Leistungshalbleiter (IGBT) aufweist, wobei die Ansteuerung als Treiber (T) ausgebildet ist, welcher mittels einer Logikbaugruppe (LB) dazu eingerichtet ist, Überspannungsereignisse zu erkennen und bei einem Überspannungsereignis den Leistungshalbleiter (IGBT) bis zum Abklingen des Ereignisses zu aktivieren sowie hierfür die Ansteuerung des Leistungshalbleiters (IGBT) mit einer erhöhten Gatespannung von bis zu 100 V bei steiler Schaltflanke erfolgt, wobei weiterhin der Treiber (T) als Verstärker ausgebildet ist und die erhöhte Gatespannung des Leistungshalbleiters (IGBT) bereitstellt, so dass sich dessen Stromtragfähigkeit erhöht, wobei die Logikbaugruppe (LB) Mittel zur Bewertung von Überspannungsereignissen im Nanosekundenbereich aufweist und ein Ausgangssignal zur Ansteuerung des Leistungshalbleiters (IGBT) in Abhängigkeit von der erkannten Überspannungsimpulslänge, nämlich schnelle transiente Ereignisse oder temporäre Überspannungen (TOV) bereitstellt.

2. Schaltungsanordnung nach Anspruch 1, **dadurch gekennzeichnet, dass** an den Ausgangsanschlüssen ein Thyristor (TH) vorgesehen ist, welcher mit der Logikbaugruppe (LB) in Verbindung steht, wobei die Logikbaugruppe (LB) zeitlich koordiniert den Thyristor (TH) zum Zweck einer Folgestrombegrenzung aktiviert.

3. Schaltungsanordnung nach Anspruch 1 oder 2, **dadurch gekennzeichnet, dass** die Logikbaugruppe (LB) einen Mikrokontroller (µC) aufweist, dessen Signaleingang ein Komparator (K) parallel geschalten ist, wobei die Ausgänge des Mikrokontrollers (µC) und des Komparators (K) auf je einen Eingang einer Verstärkerschaltung (T) gelangen, deren Ausgang auf das Gate des Leistungshalbleiters (IGBT) führt, weiterhin am Eingang der Einheit gegen Überspannungen eine TVS-Diode (TVS1) angeschlossen ist, die mit dem Signaleingang des Mikrokontrollers (µC) in Verbindung steht und bei Durchbruch ein Triggersignal liefert.

4. Schaltungsanordnung nach Anspruch 3, **dadurch gekennzeichnet, dass** zwischen dem Gate des Leistungshalbleiters (IGBT) und dessen Kollektor eine Clampingdiode (TVS2) angeordnet ist.

## Claims

1. A circuit arrangement for protecting a unit against overvoltage which is to be operated from a power supply network, comprising an input (E) having first and second input terminals, which are adapted to be connected to the power supply network, and an output (A) having first and second output terminals, to which the unit to be protected can be connected, and comprising a protective circuit that is provided between the first and second input terminals for limiting the voltage applied to it, wherein the protective circuit includes a power semiconductor (IGBT) and a drive for the power semiconductor (IGBT), wherein the drive is in the form of a driver (T) which, by means of a logic module (LB), is configured to detect overvoltage events and, in the case of an overvoltage event, to activate the power semiconductor (IGBT) until the event has subsided, and for this purpose, the power semiconductor (IGBT) is driven at an increased gate voltage of up to 100 V with a steep switching edge, wherein furthermore the driver (T) is formed as an amplifier and provides the increased gate voltage of the power semiconductor (IGBT) so that the current-carrying capacity thereof increases, wherein the logic module (LB) includes means for assessing overvoltage events in the nanosecond range and provides an output signal for driving the power semiconductor (IGBT) as a function of the detected overvoltage pulse length, namely fast transient events or temporary overvoltages (TOV).

2. The circuit arrangement according to claim 1, **characterized in that** a thyristor (TH) is provided at the output terminals and is connected to the logic module (LB), the logic module (LB) activating the thyristor (TH) in a time-coordinated manner for the purpose of a follow current limitation.

3. The circuit arrangement according to claim 1 or 2, **characterized in that** the logic module (LB) includes a microcontroller (µC) having a signal input to which a comparator (K) is connected in parallel, wherein the outputs of the microcontroller (µC) and of the comparator (K) each arrive at an input of an amplifier circuit (T) the output of which leads to the gate of the power semiconductor (IGBT), wherein furthermore the input of the unit against overvoltage has a TVS diode (TVS1) connected to it, which is in connection with the signal input of the microcontroller (µC) and supplies a trigger signal in the case of breakdown.

4. The circuit arrangement according to claim 3, **characterized in that** a clamping diode (TVS2) is arranged between the gate of the power semiconductor (IGBT) and the collector thereof.

## Revendications

1. Agencement de circuit pour la protection d'une unité à mettre en œuvre à partir d'un réseau d'alimentation contre des surtensions, comprenant une entrée (E) qui présente un premier et un deuxième raccord d'entrée aptes à être reliés au réseau d'alimentation, et une sortie (A) présentant un premier et un deuxième raccord de sortie auxquels l'unité à protéger peut être connectée, et comprenant un circuit de protection qui est prévu entre le premier et le deuxième raccord d'entrée pour limiter la tension appliquée sur celui-ci, le circuit de protection présentant un semi-conducteur de puissance (IGBT) et une commande pour le semi-conducteur de puissance (IGBT), la commande étant réalisée sous forme de pilote (T) qui est aménagé de manière à détecter, au moyen d'un module logique (LB), des évènements de surtension et, dans le cas d'un évènement de surtension, à activer le semi-conducteur de puissance (IGBT) jusqu'à la décroissance de l'évènement, et la commande du semi-conducteur de puissance (IGBT) étant à cet effet effectuée à une tension de grille augmentée allant jusqu'à 100 V avec un flanc de commutation raide, le pilote (T) étant en outre réalisé sous forme d'amplificateur et fournissant la tension de grille augmentée du semi-conducteur de puissance (IGBT), de sorte que la capacité de conduction de courant de celui-ci augmente, le module logique (LB) présentant des moyens d'évaluation d'évènements de surtension dans la plage des nanosecondes et fournissant un signal de sortie pour la commande du semi-conducteur de puissance (IGBT) en fonction de la longueur de l'impulsion de surtension détectée, à savoir des évènements transitoires rapides ou des surtensions temporaires (TOV).

2. Agencement de circuit selon la revendication 1, **caractérisé en ce qu'**un thyristor (TH) est prévu au niveau des raccords de sortie, lequel est en communication avec le module logique (LB), le module logique (LB) activant le thyristor (TH) de manière coordonnée dans le temps pour une limitation de courant de suite.

3. Agencement de circuit selon la revendication 1 ou 2, **caractérisé en ce que** le module logique (LB) présente un microcontrôleur (µC) à l'entrée de signal duquel un comparateur (K) est couplé en parallèle, les sorties du microcontrôleur (µC) et du comparateur (K) parvenant chacune à une entrée d'un circuit amplificateur (T) dont la sortie mène à la grille du semi-conducteur de puissance (IGBT), une diode TVS (TVS1) qui est en communication avec l'entrée de signal du microcontrôleur (µC) et qui fournit un signal de déclenchement lors d'un claquage étant en outre connectée à l'entrée de l'unité contre les surtensions.

4. Agencement de circuit selon la revendication 3, **caractérisé en ce qu'**une diode de clampage (TVS2) est agencée entre la grille du semi-conducteur de puissance (IGBT) et le collecteur de celui-ci.
